# EUROPÄISCHE PATENTSCHRIFT

(11) **EP 1 186 217 B1**
(45) Veröffentlichungstag und Bekanntmachung des Hinweises auf die Patenterteilung: **11.12.2002**
(21) Anmeldenummer: 00943601.5
(22) Anmeldetag: 15.05.2000
(51) Int. Cl.: H05K 7/20

(54) **ABDECKUNG FÜR LEITERPLATTEN**
COVER FOR PRINTED CIRCUIT BOARDS
COUVERCLE POUR PLAQUE DE CIRCUIT IMPRIME

(30) Priorität: 26.05.1999 DE 29909161 U
(43) Veröffentlichungstag der Anmeldung: 13.03.2002
(73) Patentinhaber: Rittal Electronic Systems GmbH & Co. KG, 90542 Eckental (DE)
(72) Erfinder: KONOPKA, Andreas, D-90471 Nürnberg (DE); SCHAFFER, Kurt-Michael, D-90542 Eckental (DE)
(74) Vertreter: Fleck, Hermann-Josef, Dr.-Ing.
(86) Internationale Anmeldenummer: DE0001534
(87) Internationale Veröffentlichungsnummer: WO00074455

(56) Entgegenhaltungen:
- WO-A-98/07305
- DE-A- 3 506 798
- US-A- 3 348 609
- US-A- 5 285 350

## Beschreibung

Die Erfindung betrifft eine Abdeckung für Leiterplatten. Hiermit kann insbesondere die Lötunterseite einer Leiterplatte zum Schutz gegen elektrische Kontaktierungen mit benachbarten Leiterplatten versehen werden. Bei Bedarf kann in entsprechender Weise auch die Bauteileoberseite einer Leiterplatte mit einer Abdeckung versehen werden.

Eine Leiterplatte gemäß dem Oberbegriff des Anspruchs 1 ist aus US-A-5 285 350 bekannt.

Abdeckungen der obigen Art sind z.B. aus dem Katalog RITTAL Elektronik, Das Handbuch für Packaging - Aufgaben, Ausgabe 11/1998, Seite 147 bekannt. Eine weitere Abdeckung ist aus dem Katalog FISCHER elektronik, 1999, Kühlkörper, 19" Technik, Steckverbinder, Seite H105 bekannt. Schließlich zeigt auch das Dokument SCHROFF, Katalog für die Elektronik 1999/2000, Seite 63.10, Zubehör, entsprechende Abdeckungen.

Diese bekannten Abdeckungen weisen den Nachteil auf, daß sie geschlossen sind. Dies kann insbesondere dann zu thermischen Problemen führen, wenn auch auf der Lötunterseite der Leiterplatte elektrische Bauelemente angebracht sind.

Der Erfindung liegt die Aufgabe zugrunde, eine Abdeckung für Leiterplatten anzugeben, womit diese Probleme vermieden werden können.

Die Aufgaben wird gelöst mit der in den Ansprüchen angegebenen Abdeckung. Die erfindungsgemäße Abdeckung ist mit bevorzugt bohrungsartigen Lüftungsöffnungen versehen, welche insbesondere in der Art einer Perforation bzw. in Feldern angeordnet sind. Bei Bedarf kann auch die gesamte Oberfläche der Abdeckung Lüftungsöffnungen aufweisen. Weitere vorteilhafte Ausgestaltungen sind in den Unteransprüchen enthalten. Die Erfindung wird an Hand der nachfolgend kurz angegebenen Figuren näher erläutert. Dabei zeigt
- Figur 1:: eine perspektivische Seitenansicht auf ein erstes Ausführungsbeispiel einer Abdeckung gemäß der Erfindung in einer flächigen Ausführung, und
- Figur 2:: eine Draufsicht auf ein zweites Ausführungsbeispiel einer Abdeckung gemäß der Erfindung in einer haubenförmigen Ausführung.

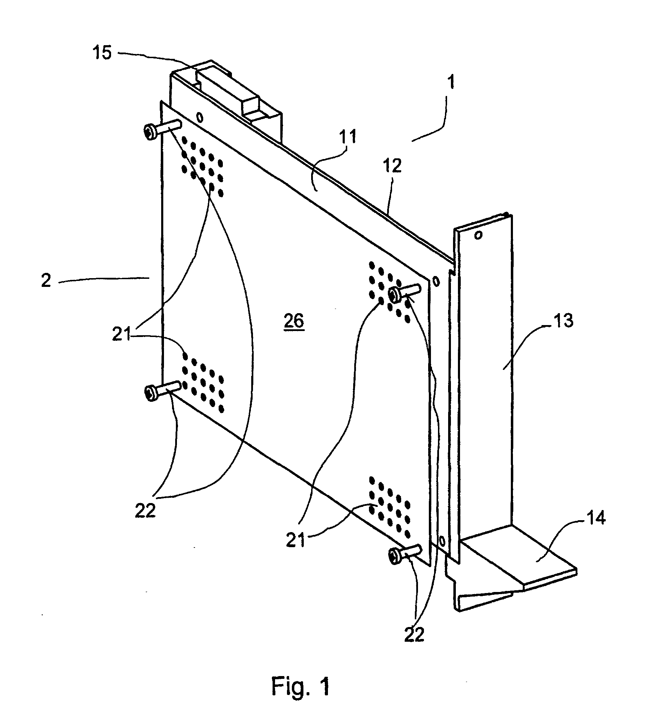

Figur 1 zeigt beispielhaft eine Leiterplatte 1, welche eine Bauteileoberseite 12 und eine Lötunterseite 11 aufweist. Gegebenenfalls kann auch die Lötunterseite 11 mit flachen Bauteilen bestückt sein. An der Stirnseite der Leiterplatte 1 ist eine Frontplatte 13 mit einem Hebelziehgriff, an der Rückseite ein vielpoliger Steckverbinder 15 angebracht.

Im Beispiel der Figur 1 ist eine flächige Abdeckung 2 dargestellt, welche zur Befestigung an einer Lötunterseite 11 vorgesehen ist. Hierzu sind an den Ecken vier Befestigungsmittel vorhanden, beispielhaft in Form von Befestigungsschrauben 22. Erfindungsgemäß weist die Abdeckung 2 auf deren Oberfläche 26 Lüftungsöffnungen 21 auf, welche beispielhaft in vier Feldern angeordnet sind. Bei anderen, nicht dargestellten Ausführungen kann auch die gesamte Oberfläche 26 in der Art eines Rasters bzw. nur entlang der Ränder der Oberfläche 26 in Form einer Perforation mit Lüftungsöffnungen versehen sein. Hiermit kann insbesondere von der Lötunterseite 11 der Leiterplatte 1 abgehende und von dort gegebenenfalls befindlichen Bauelementen erzeugte Abwärme sehr effektiv abgeleitet werden.

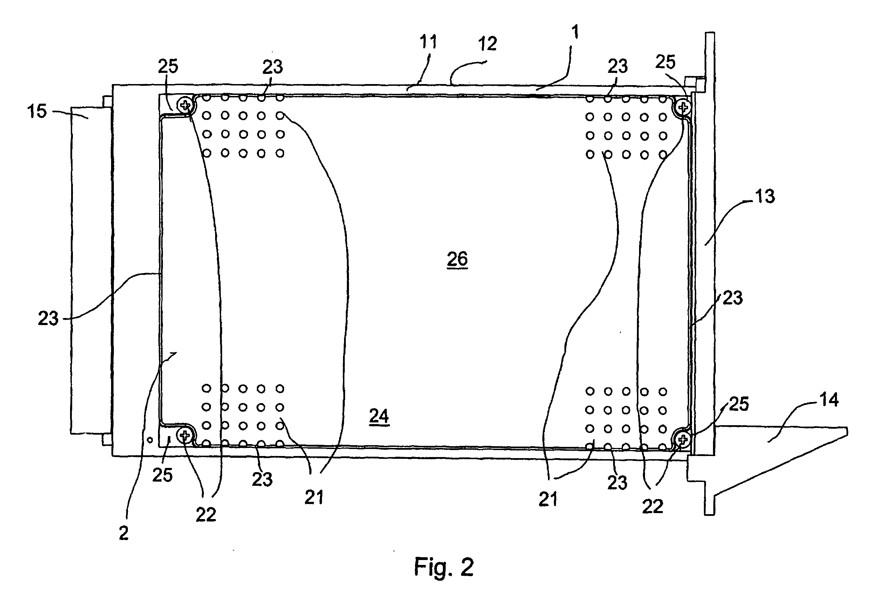

Figur 2 zeigt beispielhaft in Form einer Draufsicht eine zweite Ausführungsform der erfindungsgemäßen Abdeckung. Diese weist zusätzlich einen, die Oberfläche 26 umlaufenden Rand 23 auf, welche im montierten Zustand auf der Lötunterseite 11 der Leiterplatte 1 aufliegt. Abhängig von der jeweiligen Anwendung kann dieser Rand eine unterschiedliche Höhe aufweisen. Diese Abdeckung hat somit die Form einer Haube. Vorteilhaft erstrecken sich dabei einzelne Lüftungsöffnungen 21 auch bis in diese Randbereiche 23. Bevorzugt können ferner einzelne Lüftungsöffnungen vollständig in diesem Randbereich angeordnet sein. Dies hat den Vorteil, daß trotz der vollständig Kapselung der Lötunterseite 11 der Leiterplatte 1 eine wirkungsvolle Zuführung von Kühlluft und Abführung von Warmluft in bzw. aus dem Hohlraum zwischen Abdeckung 2 und Lötunterseite 1 möglich ist. Dieser Kühlluftstrom ist besonders effektiv, wenn die Leiterplatte senkrecht stehend z.B. in einem Baugruppenträger eingebaut ist.

Vorteilhaft kann die Abdeckung aus Metall gefertigt sein. Dies bietet Vorteile bei der Wärmeabführung und der Abschirmung gegen elektromagnetische Ein- und Abstrahlungen. Zur Isolation ist die Innenseite, welche der Lötunterseite 11 der Leiterplatte zugewandt ist, dann mit einer Isolierschicht belegt.

Bei einer anderen Ausführung kann die Abdeckung 2 zumindest im Kern auch aus einem Kunststoff gefertigt sein. In diesem Fall ist es vorteilhaft, wenn die Oberfläche 26 auf der Außenseite der Abdeckung 2 eine Metallisierung aufweist. Auch hierdurch kann sowohl die Abstrahlungsfähigkeit von Verlustwärme aus dem Hohlraum zwischen Abdeckung und Leiterplatte einerseits, und die Abschirmwirkung gegen elektromagnetische Ein- und Abstrahlungen andererseits erheblich verbessert werden. Vorteilhaft sind bei dieser Ausführung auch die Auflageflächen 25 für die Befestigungsschrauben 22 an den Rändern der Abdeckung 2 metallisiert. Auf diese Weise kann eine elektrisch leitende Verbindung zwischen der Metallisierung und z.B. einem Masseanschluß auf der Leiterplatte hergestellt werden.

## Patentansprüche

1. Leiterplatte (1) mit einer flächigen Abdeckung (2), wobei die Leiterplatte (1) eine Bauteiloberseite (12) und eine Lötunterseite (11) aufweist, wobei die Abdeckung (2) eine, von Lüftungsörfnungen (21) durchdrungene, Oberfläche (26) aufweist,
**dadurch gekennzeichnet,**
**dass** die Oberfläche (26) der Abdeckung (2) einen umtaufenden Rand (23) aufweist, welcher im montierten Zustand auf der Lötunterseite der Leiterplatte (1) aufliegt.

2. Leiterplatte nach Anspruch 1,
**dadurch gekennzeichnet,**
**dass** die Lüftungsöffnungen (21) Bohrungen sind.

3. Leiterplatte nach Anspruch 1 oder 2,
**dadurch gekennzeichnet,**
**dass** sich die Lüftungsöffnungen (21) in der Art einer Perforation zumindest an den Seiten der Oberfläche (26) befinden.

4. Leiterplatte nach einem der vorangegangenen Ansprüche.
**dadurch gekennzeichnet,**
**dass** die Lüftungsöffnungen (21) Felder bilden.

5. Leiterplatte nach einem der vorangegangenen Ansprüche,
**dadurch gekennzeichnet,**
**dass** einen die Oberfläche (26) sich die Lüftungsöffnungen in den haubenförmig um aufenden Rand (23) erstrecken.

6. Leiterplatte nach einem der vorangegangenen Ansprüche,
**gekennzeichnet durch** vollständig im Randbereich angeordnete Lüftungsöffnungen (21).

7. Leiterplatte nach einem der vorangegangenen Ansprüche,
**gekennzeichnet durch** einen aus Kunststoff bestehenden Kern mit einer Metallisierung (24) auf der Außenseite der Oberfläche (26).

8. Leiterplatte nach Anspruch 7,
**gekennzeichnet durch** metallisierte Auflageflächen (25) für Befestigungsmittel, insbesondere Befestigungsschrauben (22).

9. Leiterplatte nach einem der vorangegangenen Ansprüche 1 bis 7,
**gekennzeichnet durch** einen aus Metall bestehenden Kern.

10. Leiterplatte nach Anspruch 9,
**gekennzeichnet durch** eine Isolierschicht auf einer der Leiterplatte (1) zugewandten Innenseite.

## Claims

1. Printed circuit board (1) with a surface-area cover (2), the printed circuit board (1) having an upper component side (12) and a lower soldering side (11), the cover (2) having a surface (26) which is penetrated by ventilation openings (21), **characterized in that** the surface (26) of the cover (2) has a peripheral rim (23), which in the mounted state rests on the lower soldering side of the printed circuit board (1).

2. Printed circuit board according to Claim 1, **characterized in that** the ventilation openings (21) are drilled holes.

3. Printed circuit board according to Claim 1 or 2, **characterized in that** the ventilation openings (21) are located at least at the sides of the surface (26) in the manner of a perforation.

4. Printed circuit board according to one of the preceding claims, **characterized in that** the ventilation openings (21) form fields.

5. Printed circuit board according to one of the preceding claims, **characterized by** a rim (23) which extends around the periphery of the surface (26) in the form of a shroud and into which ventilation openings extend.

6. Printed circuit board according to one of the preceding claims, **characterized by** ventilation openings (21) arranged entirely in the region of the rim.

7. Printed circuit board according to one of the preceding claims, **characterized by** a core consisting of plastic with a metallization (24) on the outer side of the surface (26).

8. Printed circuit board according to Claim 7, **characterized by** metallized supporting surfaces (25) for fastening means, in particular fastening screws (22).

9. Printed circuit board according to one of the preceding Claims 1 to 7, **characterized by** a core consisting of metal.

10. Printed circuit board according to Claim 9, **characterized by** an insulating layer on an inner side facing the printed circuit board (1).

## Revendications

1. Plaquette de circuits imprimés (1) avec un couvercle plat (2), dans laquelle la plaquette de circuits imprimés (1) présente une face supérieure,pour composants (12) et une face inférieure de brasage (11), dans laquelle le couvercle (2) présente une surface (26) percée par des ouvertures d'aération (21), **caractérisée en ce que** la surface (26) du couvercle (2) présente un bord périphérique (23), qui à l'état monté repose sur la face inférieure de brasage de la plaquette de circuits imprimés (1).

2. Plaquette de circuits imprimés suivant la revendication 1, **caractérisée en ce que** les ouvertures d'aération (21) sont des trous forés.

3. Plaquette de circuits imprimés suivant la revendication 1 ou 2, **caractérisée en ce que** les ouvertures d'aération (21) se trouvent à la manière d'une perforation au moins sur les côtés de la surface (26).

4. Plaquette de circuits imprimés suivant l'une quelconque des revendications précédentes, **caractérisée en ce que** les ouvertures d'aération (21) forment des champs.

5. Plaquette de circuits imprimés suivant l'une quelconque des revendications précédentes, **caractérisée en ce que** les ouvertures d'aération s'étendent dans un bord (23) entourant la surface (26) à la manière d'une hotte.

6. Plaquette de circuits imprimés suivant l'une quelconque des revendications précédentes, **caractérisée par** des ouvertures d'aération (21) disposées entièrement dans la région du bord.

7. Plaquette de circuits imprimés suivant l'une quelconque des revendications précédentes, **caractérisée par** un coeur constitué de matière plastique avec une métallisation (24) sur la face extérieure de la surface (26) .

8. Plaquette de circuits imprimés suivant la revendication 7, **caractérisée par** des faces d'appui métallisées (25) pour des moyens de fixation, en particulier des vis de fixation (22).

9. Plaquette de circuits imprimés suivant l'une quelconque des revendications 1 à 7, **caractérisée par** un coeur constitué de métal.

10. Plaquette de circuits imprimés suivant la revendication 9, **caractérisée par** une couche isolante sur une face intérieure tournée vers la plaquette de circuits imprimés (1).
